(19) Europäisches Patentamt
European Patent Office
Office européen des brevets

(11) **EP 3 631 480 B1**

(12) **FASCICULE DE BREVET EUROPEEN**

(45) Date de publication et mention
de la délivrance du brevet:
**15.03.2023 Bulletin 2023/11**

(21) Numéro de dépôt: **18728854.3**

(22) Date de dépôt: **29.05.2018**

(51) Classification Internationale des Brevets (IPC):
**G01R 31/58** *(2020.01)* **G01V 3/15** *(2006.01)*
**G01V 15/00** *(2006.01)* **H02G 3/00** *(2006.01)*

(52) Classification Coopérative des Brevets (CPC):
**G01V 3/15; G01R 31/58; G01V 15/00;** H02G 3/00;
H02G 2200/20

(86) Numéro de dépôt international:
**PCT/EP2018/064088**

(87) Numéro de publication internationale:
**WO 2018/219960 (06.12.2018 Gazette 2018/49)**

(54) **DISPOSITIF DE DETECTION A DISTANCE DE CABLES ELECTRIQUES MULTI-COEURS**

VORRICHTUNG ZUR REMOTE-VERBINDUNG VON ELEKTRISCHEN MEHRADRIGEN KABELN

DEVICE FOR THE REMOTE DETECTION OF MULTICORE ELECTRICAL CABLES

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **30.05.2017 FR 1754746**

(43) Date de publication de la demande:
**08.04.2020 Bulletin 2020/15**

(73) Titulaires:
• **Commissariat à l'Énergie Atomique
et aux Énergies Alternatives
75015 Paris (FR)**
• **Nexans
92070 Paris La Défence cedex (FR)**

(72) Inventeurs:
• **FRASSATI, François
38340 Voreppe (FR)**
• **THOMAS, Thierry
38760 Varces Alli res et Risset (FR)**
• **MASCIA, Jean Pierre
01960 Peronnas (FR)**
• **TUNDO, Alessandro
69007 Lyon (FR)**

(74) Mandataire: **Cabinet Beaumont
4, Place Robert Schuman
B.P. 1529
38025 Grenoble Cedex 1 (FR)**

(56) Documents cités:
DE-A1-102004 051 594    US-A1- 2007 120 684
US-A1- 2009 272 794    US-A1- 2010 172 618

**Description**

La présente demande de brevet revendique la priorité de la demande de brevet français FR17/54746.

Domaine

La présente demande concerne un dispositif de détection à distance de câbles électriques multi-coeurs.

Exposé de l'art antérieur

Les câbles électriques, notamment basse et moyenne tension, peuvent comprendre un conducteur unique, on parle alors de câbles mono-coeur, entouré d'une ou plusieurs gaines isolantes, ou peuvent comprendre plusieurs conducteurs, on parle alors de câbles multi-coeurs, l'ensemble des conducteurs pouvant en outre être entouré d'une gaine isolante. Les conducteurs d'un câble multi-coeurs sont en outre généralement entourés, individuellement, d'une gaine isolante. Les câbles multi-coeurs permettent par exemple d'alimenter plusieurs appareils ou composants électriques.
Un câble électrique multi-coeurs peut comprendre deux conducteurs, trois conducteurs ou plus de trois conducteurs. Les conducteurs électriques d'un câble peuvent être assemblés, par exemple torsadés. Ceci permet de constituer un câble dans lequel les conducteurs sont mécaniquement solidaires les uns des autres, ce qui facilite leur mise en place. Ceci permet en outre d'éviter l'émission d'un rayonnement de parasites électromagnétiques vers l'extérieur.
Pour certaines applications, il est souhaitable de pouvoir détecter à distance des câbles électriques, apparents ou cachés, notamment pour les identifier et/ou les localiser.
Un exemple d'application concerne l'identification de câbles lorsqu'il y a un grand nombre de câbles dans un volume réduit, notamment pour la connexion de câbles sur des armoires électriques ou des serveurs informatiques. L'identification des câbles permet d'éviter des erreurs de connexion. L'identification peut être réalisée par l'utilisation de différentes couleurs de câbles ou bien d'étiquettes fixées aux câbles. Un inconvénient de ces procédés d'identification est qu'ils requièrent d'avoir accès aux câbles. L'identification peut en outre être réalisée par l'utilisation d'étiquettes RFID (sigle anglais pour Radio Frequency Identification), intégrées dans les câbles. L'identification se fait par lecture de l'étiquette RFID à quelques centimètres du connecteur. Un inconvénient de ces procédés d'identification des câbles est qu'il requiert d'avoir accès aux connecteurs des câbles.
Un autre exemple d'application concerne la localisation, et éventuellement l'identification, de câbles lorsqu'ils sont enfouis, notamment dans un plancher, un plafond ou une cloison, ou enterrés. Pour une telle application, il pourrait être envisagé de placer des étiquettes RFID à l'intérieur de boîtiers fixés au câble à intervalles réguliers. Un inconvénient est que le câble présente alors une protubérance et ne peux pas être installé dans un fourreau. De plus, ce procédé nécessite une opération supplémentaire lors de la pose.
Il pourrait en outre être envisagé d'intégrer des étiquettes RFID à l'intérieur du câble lors de sa fabrication, par exemple dans la gaine de protection externe du câble comme cela est décrit dans la demande de brevet WO2008122401. Une étiquette RFID comprend une antenne pour l'échange de signaux radiofréquences avec un lecteur. Les dimensions de l'antenne déterminent à quelle distance une détection de l'étiquette RFID est possible par le lecteur. Un inconvénient est que pour une détection à une distance importante, par exemple supérieure à 50 cm, une antenne ayant un rayon important doit être utilisée. Le diamètre d'un câble électrique multi-coeurs pouvant être de l'ordre de 40 mm, il peut alors être nécessaire de courber l'antenne pour pouvoir l'intégrer au câble. Le cintrage de l'antenne réduit la surface utile de l'antenne pouvant être réellement détectée par un lecteur.
En outre, dans un câble électrique multi-coeurs, chaque conducteur comprend généralement un blindage, généralement une enveloppe métallique entourant le conducteur. Cette enveloppe métallique peut être mise à la terre et permet alors de transporter vers la terre un éventuel courant de court-circuit, notamment dans le cas d'une détérioration du câble. Une étiquette RFID intégrée dans la gaine du câble serait alors située au contact mécanique du blindage. Un inconvénient est que la proximité immédiate du blindage peut entraîner une réduction du flux magnétique passant au travers de l'antenne et réduire la portée à laquelle l'étiquette RFID comprenant cette antenne peut être détectée.
Un autre inconvénient de l'intégration d'étiquettes RFID dans la gaine du câble est que l'orientation du câble et de l'étiquette RFID intégrée n'est pas maîtrisée lors de la pose du câble. Or l'étiquette RFID ne répond au lecteur que si elle reçoit une quantité de flux magnétique suffisante pour permettre son activation. Ceci suppose que l'antenne de l'étiquette RFID intercepte suffisamment de lignes de champ magnétiques, ce qui peut ne pas être le cas si l'étiquette RFID n'est pas orientée correctement par rapport au lecteur.
Des documents pertinents de l'état de la technique sont US 2010/172618 A1, US 2007/120684 A1, US 2009/272794 A1 et DE 10 2004 051594 A1.

**EP 3 631 480 B1**

Résumé

Un objet d'un mode de réalisation est de prévoir un câble electrique multi-coeurs comprenant un dispositif de détection du câble à distance palliant tout ou partie des inconvénients des dispositifs de détection décrits précédemment.
Un autre objet d'un mode de réalisation est que la détection du dispositif de détection peut être réalisée quelle que soit l'orientation du câble.
Un autre objet d'un mode de réalisation est que le dispositif de détection peut être utilisé avec un câble electrique multi-coeurs dont chaque conducteur comprend un blindage.
Un autre objet d'un mode de réalisation est que le dispositif de détection peut être utilisé avec des conducteurs assemblés, par exemple torsadés.
Un dispositif de détection selon l'invention est défini dans la revendication indépendante 1. Des modes de réalisation sont définis dans les revendications dépendantes.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

les figures 1, 2 et 3 sont respectivement une vue en perspective, une vue en coupe et une vue éclatée, partielles et schématiques, d'un mode de réalisation d'un câble electrique multi-coeurs comprenant un dispositif de détection à distance ;
la figure 4 est une vue de face, partielle et schématique, d'un mode de réalisation d'une étiquette RFID ;
la figure 5 illustre un procédé de détection d'un câble electrique multi-coeurs ;
la figure 6 représente des courbes, obtenues par simulation, d'évolution du maximum et du minimum du flux reçu par le dispositif de détection en fonction de l'orientation du câble ;
la figure 7 représente de façon schématique une modélisation d'un câble electrique multi-coeurs comprenant un dispositif de détection utilisé pour réaliser des simulations ;
les figures 8, 9 et 10 sont respectivement une vue en perspective, une vue en coupe et une vue éclatée, partielles et schématiques, d'un autre mode de réalisation d'un câble electrique multi-coeurs comprenant un dispositif de détection à distance ;
les figures 11 à 13 sont des vues en coupe, partielles et schématiques, d'autres modes de réalisation d'un câble electrique multi-coeurs comprenant un dispositif de détection à distance ; et
les figures 14 et 15 sont respectivement une vue en coupe et une vue en perspective, partielles et schématiques, d'un autre mode de réalisation d'un câble electrique multi-coeurs comprenant un dispositif de détection à distance.

Description détaillée

De mêmes éléments ont été désignés par de mêmes références dans les différentes figures et, de plus, les diverses figures ne sont pas tracées à l'échelle. Dans la description qui suit, lorsque l'on fait référence à des qualificatifs de position relative, tels que les termes "dessus", "dessous", "supérieur", "inférieur", etc., il est fait référence à l'orientation des figures ou à un câble electrique dans une position normale d'utilisation. Par souci de clarté, seuls les éléments utiles à la compréhension des modes de réalisation décrits ont été représentés et sont détaillés. En particulier, les lecteurs d'étiquettes RFID sont bien connus de l'homme du métier et ne sont pas décrits en détail par la suite. Sauf précision contraire, les expressions "approximativement", "sensiblement", "environ" et "de l'ordre de" signifient à 10 % près, de préférence à 5 % près.
Les procédés d'échange de données à distance utilisent une antenne pour l'émission et/ou la réception d'un rayonnement électromagnétique. Il existe plusieurs procédés d'échange de données sans contact. La radio-identification, le plus souvent désignée par le sigle RFID (de l'anglais Radio Frequency Identification), est une méthode utilisant le champ électromagnétique pour identifier et suivre des marqueurs, appelés étiquettes RFID, liés à des objets. Un autre exemple de procédé d'échange de données sans contact est la communication en champ proche (NFC, sigle anglais pour Near Field Communication). Dans la suite de la description, des modes de réalisation vont être décrits dans le cas de l'utilisation d'étiquettes RFID. Toutefois, il est clair que ces modes de réalisation peuvent être mis en oeuvre avec n'importe quel autre procédé de communication sans contact en champ proche.
Selon un mode de réalisation, il est prévu un câble electrique multi-coeurs comprenant un support d'au moins une antenne pour la communication de données sans contact, notamment une étiquette RFID, qui est logé entre au moins deux conducteurs isolés en contact mécanique de ces conducteurs et qui occupe une partie de l'espace laissé libre entre les conducteurs isolés et l'enveloppe cylindrique délimitant l'encombrement du câble. Une partie du support peut s'immiscer entre les deux conducteurs isolés, pour améliorer la cohésion mécanique entre différentes parties du support. L'antenne est au contact du support ou intégrée au support, et est contenue dans une surface qui, dans un plan de coupe droite, a un rayon de courbure supérieur au rayon de chaque conducteur électrique formant le câble, cette surface pouvant être plane. Le support comprend, pour chacun desdits au moins deux conducteurs, une partie épousant le conducteur et présentant un rayon de courbure sensiblement égal au rayon du conducteur. Ceci permet d'améliorer le maintien du support sur les conducteurs. Le rayon de courbure est mesuré dans une section droite du câble.

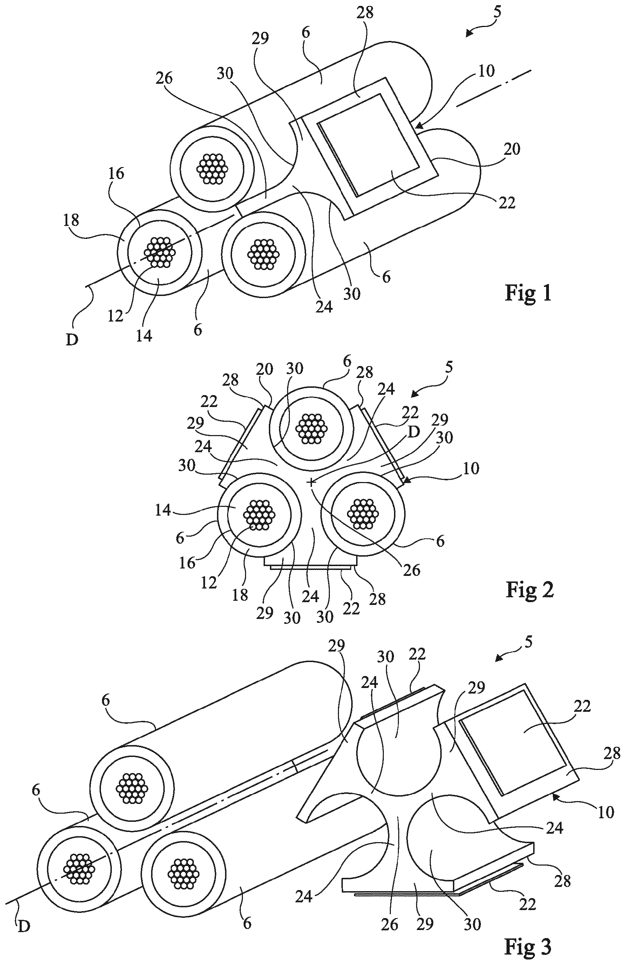

Les figures 1, 2 et 3 sont respectivement une vue en perspective, une vue en coupe et une vue éclatée, partielles et schématiques, d'un mode de réalisation d'un câble électrique multi-coeurs 5 comprenant plusieurs conducteurs 6 et un dispositif 10 de détection à distance du câble 5.

Dans le présent mode de réalisation, le câble 5 s'étend selon un axe D et comprend trois conducteurs 6 qui s'étendent autour de l'axe D. La vue en coupe de la figure 2 est réalisée dans un plan perpendiculaire à l'axe D. Chaque conducteur 6 peut comprendre plusieurs fils électriques ou brins électriques 12 contenus dans une gaine 14 isolante électriquement. La gaine 14 peut être entourée d'une couche 16 conductrice électriquement, formant un blindage, la couche 16 étant elle-même entourée d'une enveloppe 18 isolante électriquement. A titre de variante, au moins l'un des conducteurs 6, éventuellement chaque conducteur 6, peut comprendre un seul fil électrique. Chaque conducteur 6 peut avoir une forme cylindrique de diamètre compris entre 13 mm et 63 mm.

Le dispositif de détection 10 comprend un support 20 et des étiquettes RFID 22 fixées au support 20. Le support 20 comprend des branches 24 qui se projettent en étoile depuis un corps central 26, chaque branche 24 étant interposée entre deux conducteurs 6 du câble 5. Une étiquette RFID 22 ou radio-étiquette est un objet comprenant une antenne associée à un circuit électronique, non représenté sur les figures 1 à 3, qui lui permet d'échanger des signaux radiofréquences avec un lecteur. Dans le présent mode de réalisation dans lequel le câble 5 comprend des premier, deuxième et troisième conducteurs 6, le support 20 comprend des première, deuxième et troisièmes branches 24 reliées au corps central 26 à une extrémité, la première branche 24 étant interposée entre les premier et deuxième conducteurs 6, la deuxième branche 24 étant interposée entre les deuxième et troisième conducteurs 6 et la troisième branche 24 étant interposée entre les premier et troisième conducteurs 6.

Le support 20 comprend des faces 28, chaque étiquette RFID 22 étant fixée à l'une des faces 28, par exemple par collage. Selon un autre mode de réalisation, le support comprend des rebords, non représentés, se rabattant sur les bords de chaque étiquette RFID 22 permettant le maintien des étiquettes.

Dans le mode de réalisation représenté sur les figures 1 à 3, chaque branche 24 comprend, du côté opposé au corps central 26, une portion évasée 29 délimitant une surface correspondant à l'une des faces 28. Selon un mode de réalisation, chaque face 28 est sensiblement plane. Selon un autre mode de réalisation, chaque face 28 peut être bombée vers l'extérieur, chaque étiquette RFID 22 pouvant alors épouser la forme bombée de la face 28 à laquelle elle est fixée. Ceci permet de façon avantageuse de faciliter le gainage du câble 5. Chaque branche 24 comprend des parois latérales 30 ayant sensiblement la forme d'un secteur cylindrique, les parois latérales 30 opposées de deux branches 24 délimitant un logement sensiblement cylindrique recevant l'un des conducteurs 6.

Selon un mode de réalisation, les branches 24 sont régulièrement réparties autour du corps central 26. Dans le mode de réalisation représenté sur les figures 1 à 3 dans lequel le support 20 comprend trois branches 24, les branches 24 peuvent être réparties, dans la vue de la figure 2, selon des directions inclinées de 120° l'une par rapport à l'autre.

Selon un mode de réalisation, la section droite du support 20, dans un plan perpendiculaire à l'axe D, est inscrite dans un cercle dont le diamètre est égal approximativement au diamètre du cercle circonscrit à l'ensemble des conducteurs 6. Pour trois conducteurs 6 de diamètre $D_C$ agencés de façon jointive en triangle, le diamètre $D_{ext}$ du cercle circonscrit à l'ensemble des conducteurs 6 est donné par la relation (1) suivante :

$$D_{ext} = D_C * (1 + 1/\cos(30°)) \tag{1}$$

Le support 20 peut avoir une structure monobloc et être réalisé en un polymère, notamment un polymère choisi parmi le groupe comprenant le polypropylène (PP), le polyéthylène (PE) ou un élastomère. Le support 20 peut être réalisé en un matériau rigide ou un matériau souple. Le support 20 peut correspondre à une structure creuse ou pleine.

A des fins d'illustration, chaque portion évasée 29 du support 20 a été représentée sur les figures 1 à 3 avec une surépaisseur importante par rapport au plan tangent aux conducteurs 6 entre lesquels s'étend la portion évasée 29. Selon un mode de réalisation, la surépaisseur de chaque portion évasée 29 du support 20 par rapport au plan tangent aux conducteurs 6 entre lesquels s'étend la portion évasée 29 est la plus faible possible de façon à réduire les éléments se projetant en saillie par rapport aux conducteurs 6.

Selon un mode de réalisation, une gaine extérieure peut être prévue autour du câble 5 pour obtenir une structure finale bien cylindrique sans protubérance.

Dans le mode de réalisation représenté sur les figures 1 à 3, les étiquettes RFID 22 sont fixées au support 20. Selon un autre mode de réalisation, les étiquettes RFID 22 peuvent être intégrées dans le support 20, les étiquettes RFID 22 étant par exemple noyées dans la matière du support 20 ou étant directement imprimées sur le support 20.

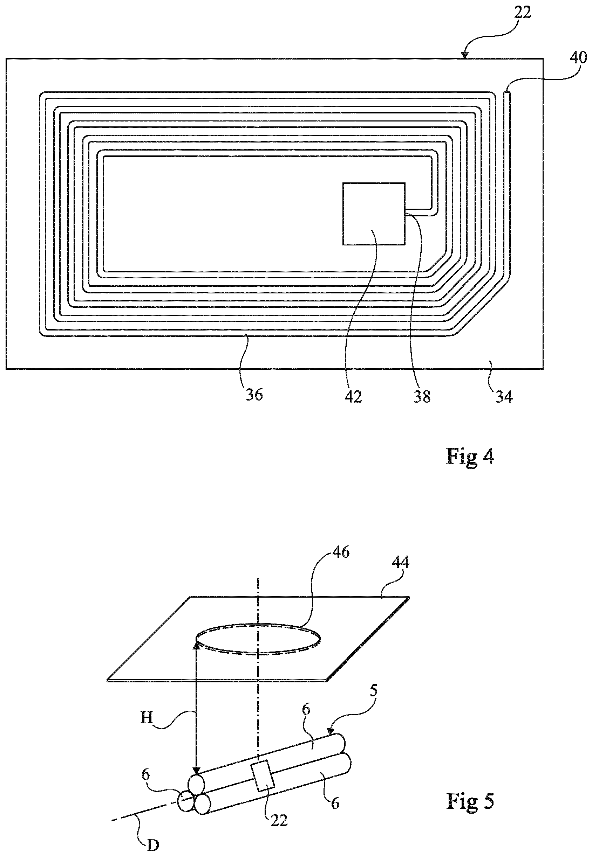

La figure 4 est une vue de face, partielle et schématique, d'un mode de réalisation de l'étiquette RFID 22.

Selon le présent mode de réalisation, chaque étiquette RFID 22 comprend :

un substrat 34, par exemple un film en polymère, notamment en poly(téréphtalate d'éthylène) (PET) ;
une antenne 36 comprenant une piste conductrice électriquement, par exemple en aluminium, s'étendant sur le substrat 34 et comprenant deux extrémités opposées 38, 40 ; et
un circuit électronique 42, par exemple une puce de circuit intégré, reposant sur le substrat 34 et connecté aux extrémités 38, 40 de la piste conductrice 36, la liaison entre le circuit électronique 42 et l'extrémité 40 n'étant pas représentée en figure 4.

Un film de protection, non représenté, peut recouvrir l'antenne 36 et/ou le circuit électronique 42.

Selon un mode de réalisation, dans la vue de dessus de la figure 4, l'antenne 36 est inscrite dans un rectangle dont le grand côté mesure entre 100 mm et 300 mm et dont le petit côté est sensiblement de l'ordre du diamètre d'un conducteur 6, par exemple de 13 mm à 65 mm. Comme illustré sur la figure 4, l'antenne 36 comprend des spires conductrices électriquement. Chaque spire est formée successivement par une portion transversale s'étendant sensiblement selon les petits côtés du gabarit rectangulaire, puis est suivie par une portion longitudinale, la portion longitudinale s'étendant alors sensiblement selon les grands côtés du gabarit rectangulaire, puis la spire comprend une deuxième portion transversale et enfin une deuxième portion longitudinale. Les dimensions d'allongement de chacune des portions varient de manière à former des spires sensiblement concentriques. La liaison entre deux spires successives est par exemple réalisée par l'ajout d'une portion oblique. A titre de variante, l'antenne peut avoir la structure décrite dans le brevet US9379442.

Par rapport au câble, il est par exemple prévu que les portions transversales présentent des directions d'allongement sensiblement perpendiculaires à l'axe D du câble et que les portions longitudinales présentent des directions d'allongement sensiblement parallèles à l'axe D du câble.

D'autres structures d'étiquettes RFID que celle représentée en figure 4 peuvent être utilisées. A titre de variante, chaque étiquette RFID 22 peut comprendre au moins deux antennes 36. En outre, le substrat 34 peut comprendre un empilement d'au moins des première et deuxième couches isolantes électriquement, au moins une première piste conductrice électriquement étant située entre les première et deuxième couches isolantes et une deuxième piste étant située sur la première couche isolante, du côté de la première couche isolante opposée à la deuxième couche isolante, les première et deuxième pistes conductrices étant connectées entre elles par des éléments conducteurs au travers de la première couche isolante et formant l'antenne 36 de l'étiquette RFID 22.

Selon un mode de réalisation, le dispositif 10 est mis en place entre les conducteurs 6 lors de la formation du câble 5 ou après la formation du câble 5. Selon un mode de réalisation, les conducteurs 6 peuvent être torsadés ensemble et le dispositif 10 peut être inséré entre les conducteurs 6 au cours de la mise en torsade de ceux-ci. Selon un autre mode de réalisation, le dispositif 10 peut être inséré entre les conducteurs 6 après la mise en torsade de ceux-ci en défaisant localement la torsade pour permettre l'insertion du dispositif 10.

De préférence, plusieurs dispositifs de localisation 10 sont disposés le long du câble 5, par exemple à intervalles réguliers, la distance entre deux dispositifs 10 adjacents étant par exemple comprise entre 0,8 m et 1,5 m.

La figure 5 illustre de façon très schématique un mode de réalisation d'un procédé de détection du câble 5. Seule une étiquette 22 du dispositif de détection 10 est représentée en figure 5.

Un procédé de détection du câble 5 comprenant le dispositif de détection 10 comprend le déplacement d'un lecteur 44, par exemple un lecteur RFID, comprenant une antenne 46 à une distance H du câble 5 pouvant varier entre 0,1 m et 1,5 m jusqu'à ce que le lecteur 44 détecte l'une des étiquettes RFID 22 du dispositif 10.

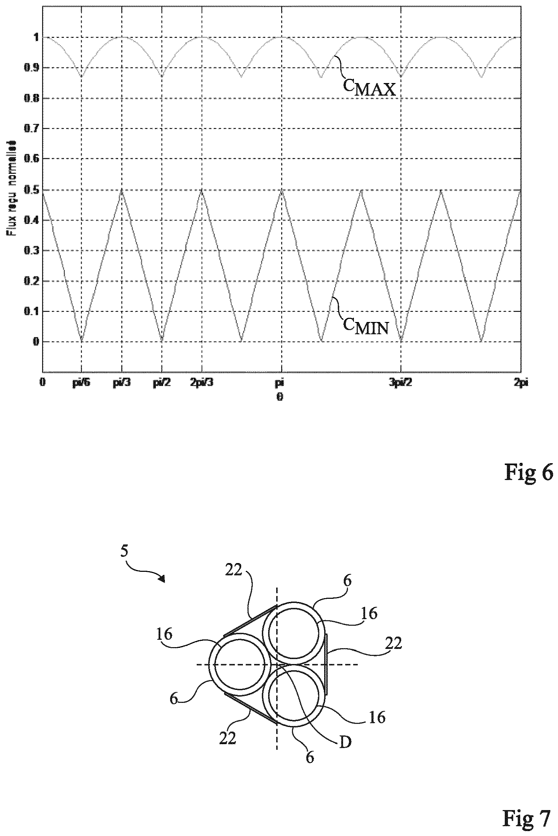

La figure 6 représente des courbes d'évolution, obtenues par simulation, du maximum, courbe $C_{MAX}$, et du minimum, courbe $C_{MIN}$, du flux reçu par les trois étiquettes RFID 22 du dispositif de détection 10 représenté sur la figure 1 en fonction de l'angle θ de rotation du câble 5 autour de l'axe D. Sur la figure 6, les flux sont normalisés et exprimés en valeur absolue. Pour les simulations, on a considéré des étiquettes RFID 22 à une spire et on a déterminé, pour chaque valeur de l'angle θ, le flux reçu par chaque étiquette RFID 22. Il a alors été conservé le maximum et le minimum des flux reçus par trois étiquettes RFID 22 pour la détermination des courbes $C_{MAX}$ et $C_{MIN}$. Dans le cas le plus défavorable, l'une des étiquettes reçoit toujours 86 % de la valeur nominal du flux reçu. Le procédé de détection est donc sensiblement indépendant de l'orientation du dispositif de détection 10 autour de l'axe D.

Chaque arche de la courbe $C_{MAX}$ correspond à l'une des étiquettes RFID 22. Sur l'intervalle 0 - 2pi, la courbe $C_{MAX}$ comprend deux arches pour chaque étiquette RFID 22. Les points de rebroussement sur la courbe $C_{MAX}$ correspondent au passage d'une étiquette RFID 22 à l'autre. A ce point de rebroussement, le niveau de flux est identique pour deux étiquettes RFID 22 et est à cos(30°), soit 0,866, du maximum de flux. Ceci implique que, pour le dispositif de détection 10, une étiquette RFID 22 doit rester fonctionnelle dans une plage de variation de son orientation d'un minimum de +/-30° par rapport à l'orientation optimale.

La figure 7 représente une modélisation du câble 5, comprenant les conducteurs 6 et le dispositif de détection 10, utilisé pour réaliser des simulations. Les conducteurs 6 sont des conducteurs mono-coeur de 38 mm de diamètre avec un blindage 16 cylindrique de 30 mm de diamètre. Dans la modélisation, les conducteurs 6 sont considérés au contact les uns avec les autres et chaque étiquette RFID 22 est sensiblement plane, disposée de façon tangentielle par rapport à deux conducteurs adjacents 6 au contact desdits conducteurs 6. Les étiquettes 22 sont réparties de façon régulière autour de l'axe D du câble 5. L'antenne de chaque étiquette RFID 22 comprend six spires rectangulaires, la moyenne des grands côtés des spires étant égale à 150 mm et la moyenne des petits côtés des spires étant égale à 35 mm.

Pour les simulations, il a été utilisé un lecteur émettant un champ magnétique qui à 1 m du câble 5 a une amplitude variant de 50 mA/m à 70 mA/m. L'ordre de grandeur de 50 mA/m à 70 mA/m a été calculé pour une antenne boucle circulaire d'un diamètre d'environ 70 cm. Le niveau de courant circulant dans cette boucle circulaire a été évalué en fonction de la puissance que le circuit électronique du lecteur peut appliquer à l'antenne et la résistance série insérée dans cette boucle pour assurer une bande passante suffisante à la communication tout en minimisant la puissance consommée pour un niveau de courant donné. La boucle antenne du lecteur est montée en résonateur RLC. La bande passante est reliée au facteur $\left(\sqrt{L/C}\right)/R$ . Un ordre de grandeur de 50 pour ce facteur est en pratique un bon compromis bande passante/ consommation. Ceci conduit à une résistance série de l'ordre de 4 ohms. Les lecteurs RFID HF grande portée actuellement disponibles dans le commerce peuvent offrir des puissances maximales de 4 W à 12 W. Avec 10 W sur 4ohms, on obtient 1,6 A ce qui conduit à un niveau de champ d'environ 70 mA/m à 1 m avec une boucle de 70 cm. Avec 5 W, on obtient environ 60 mA/m.

La surface apparente $S_a$ au flux du dispositif de détection est donnée par la relation (2) suivante :

$$S_a = \frac{M}{\mu_0 \cdot |H_0|} \qquad (2)$$

où $\mu_0$ est la perméabilité magnétique du vide (unité en Henry par mètre), $H_0$ est le niveau de champ produit par le lecteur en un point de référence de l'antenne de l'étiquette RFID pour un ampère de courant dans l'antenne du lecteur, par exemple son centre, (unité Ampère par mètre) et M est la mutuelle inductance entre le circuit d'antenne du lecteur et le circuit d'antenne de l'étiquette RFID (unité Henry) en tenant compte si le câble est présent, de la perturbation provoquée par la présence de celui-ci sur le champ produit par le lecteur.

Le volume de couplage effectif $V_{Ceff}$ du dispositif de détection est donné par la relation (3) suivante :

$$V_{Ceff} = \mu_0 \cdot \frac{S_a{}^2}{L_T} \qquad (3)$$

où $L_T$ est l'inductance du circuit d'antenne de l'étiquette RFID en tenant compte si le câble est présent, de l'influence de celui-ci sur la circulation de courant dans ce circuit d'antenne.

Les valeurs de la surface apparente au flux $S_a$ et du volume de couplage effectif $V_{Ceff}$ ont été déterminées par simulation en faisant tourner le câble 5 autour de l'axe D.

Un volume de couplage effectif $V_{Ceff}$ supérieur à environ une valeur $V_{Ceff}$min de 30 cm$^3$ est nécessaire pour permettre la détection d'une étiquette RFID placé à 1 m de la source du champ magnétique lorsque l'orientation de l'étiquette RFID est optimale. Pour que l'étiquette RFID reste fonctionnelle avec une inclinaison $\theta$ par rapport à la position optimale, le volume de couplage effectif $V_{Ceff}$ doit être supérieur à environ la valeur $V_{Ceff}$min/cos$^2\theta$. Avec l'inclinaison $\theta$ de +/-30° décrite précédemment en relation avec la figure 6, le volume de couplage effectif $V_{Ceff}$ doit être supérieur à environ 40 cm$^3$. Avec une inclinaison $\theta$ de +/-50°, pour avoir une marge de sécurité de 20°, le volume de couplage effectif $V_{Ceff}$ doit être supérieur à environ 73 cm$^3$.

En l'absence des blindages 16, la surface apparente $S_a$ du dispositif de détection est d'environ 314 cm$^2$ et le volume de couplage effectif $V_{Ceff}$ du dispositif de détection est de 210 cm$^3$. En l'absence de perturbation, la surface apparente $S_a$ est peu différente de la surface géométrique totale du dispositif de détection, égale à 6*(3,5*15)= 315 cm$^2$. La surface apparente $S_a$ est légèrement inférieure à la surface géométrique totale parce qu'elle est normalisée par le niveau de champ au centre de l'antenne de l'étiquette RFID et que le champ produit par l'antenne du lecteur n'est pas parfaitement homogène au niveau de l'antenne de l'étiquette RFID.

En présence des blindages 16, la surface apparente $S_a$ du dispositif de détection est de 131 cm$^2$ et le volume de couplage effectif $V_{Ceff}$ du dispositif de détection est de 72 cm$^3$. Le dispositif de détection 10 est donc bien détecté par le lecteur.

A titre de comparaison, une étiquette RFID unique analogue aux étiquettes RFID 22 et cintrée sur un conducteur 6 avec une couche de séparation de 2,5 mm d'épaisseur présente, en l'absence de blindage, un volume de couplage effectif $V_{Ceff}$ de 76 cm$^3$ et, en présence de blindage, un volume de couplage effectif $V_{Ceff}$ de 20 cm$^3$. Le dispositif de détection n'est donc pas détecté en présence de blindage.

Un avantage du dispositif de détection 10 représenté sur les figures 1 à 3 est que chaque antenne d'une étiquette 22 est disposée entre deux conducteurs adjacents 6 à l'emplacement où se concentrent les lignes du champ émises par le lecteur qui passent entre les conducteurs 6. La détection de l'antenne 36 est ainsi facilitée.

Un autre avantage du dispositif de détection 10 représenté sur les figures 1 à 3 est que les antennes 36 des étiquettes 22 s'étendent principalement dans l'espace entre deux conducteurs 6. Lorsque les conducteurs 6 comprennent un blindage 16, la distance entre la majorité des pistes conductrices de l'antenne 36 de l'étiquette RFID 22 et les blindages 8 adjacents est nettement plus importante que dans le cas où l'antenne de l'étiquette RFID est plaquée contre la surface du conducteur 6, toutes les pistes de l'antenne de l'étiquette RFID étant alors distantes du blindage 16 de l'épaisseur de la couche d'isolant externe du conducteur 6. Ceci permet de réduire l'influence des blindages 16 des conducteurs 6 sur les performances de l'antenne 36 de l'étiquette RFID 22.

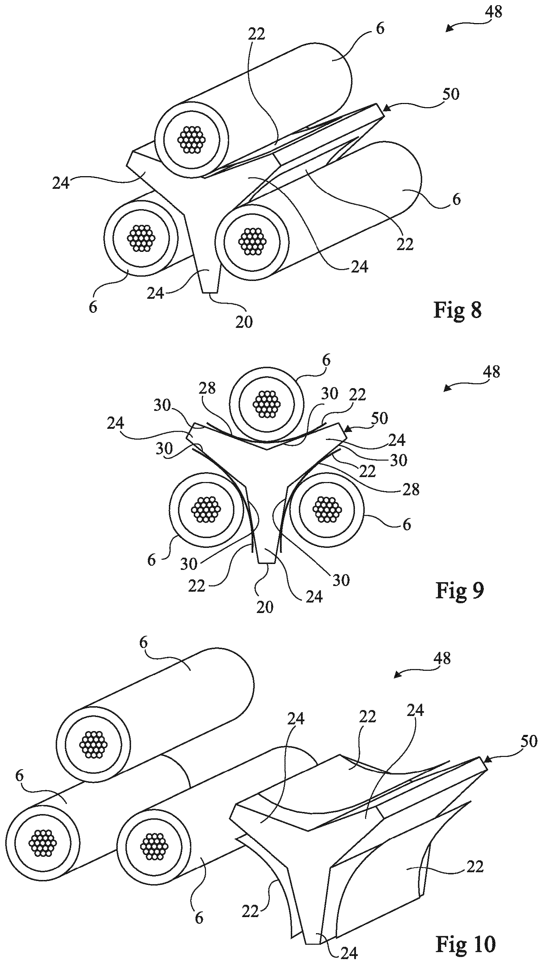

Les figures 8, 9 et 10 sont des vues analogues respectivement aux figures 1, 2 et 3 d'un autre mode de réalisation d'un câble électrique multi-coeurs 48 comprenant les conducteurs 6 et un dispositif de détection à distance 50.

Le dispositif 50 comprend l'ensemble des éléments du dispositif 10 représenté sur les figures 1 à 3 à la différence que les étiquettes 22 ne sont pas situées aux extrémités des branches 24, chaque étiquette RFID 22 s'étendant sur les parois latérales 30 de deux branches 24 qui forment les faces 28 sur lesquelles sont fixées les étiquettes RFID 22. Chaque étiquette 22 comprend une partie qui est interposée entre le support 20 et l'un des conducteurs 6.

Un avantage du dispositif de détection 50 représenté sur les figures 8 à 10 est que les étiquettes RFID 22 ne sont pas exposées à l'extérieur du câble 48 et sont protégées par les conducteurs 6.

Selon un mode de réalisation, les épaisseurs des branches 24 peuvent être inférieures à ce qui est représenté de façon schématique sur les figures 8 à 10 pour que la présence du dispositif de détection 50 n'entraîne pas une augmentation trop importante du diamètre local du câble 48.

Des simulations ont été réalisées pour déterminer la surface apparente $S_a$ au flux et le volume de couplage effectif $V_{Ceff}$ du dispositif de détection 50 représenté sur les figures 8 à 10. Pour les simulations, on a considéré la même modélisation que celle représentée en figure 7 à la différence que l'on a considéré une étiquette RFID dont l'antenne s'étend selon des premier et deuxième demi-plans inclinés de 120° l'un par rapport à l'autre, le premier demi-plan étant interposé entre les premier et deuxième conducteurs 6 et le deuxième demi-plan étant intercalé entre les deuxième et troisième conducteurs. Pour les simulations, l'antenne de l'étiquette RFID est un bobinage rectangulaire de dimensions moyennes de 65 mm par 175 mm, comprenant 3 spires (correspondant chacune à piste de 1 mm de largeur) au pas de 1,5 mm. Pour les simulations, les conducteurs 6 avaient un diamètre de 35 mm et contenaient un blindage 16 cylindrique de 30 mm de diamètre.

En l'absence de blindage 16, l'inductance du circuit de l'étiquette RFID atteint 3,32 μH. On obtient une surface apparente $S_a$ de 284 cm$^2$ (pour une antenne de lecteur correspondant à une boucle de 68 cm de diamètre placée à 1 m) et un volume de couplage effectif $V_{Ceff}$ de 318 cm$^3$. En présence des blindages 16, l'inductance du circuit de l'étiquette RFID chute à 2,57 μH. On obtient une surface apparente $S_a$ de 162 cm$^2$ et un volume de couplage effectif $V_{Ceff}$ de 129 cm$^3$.

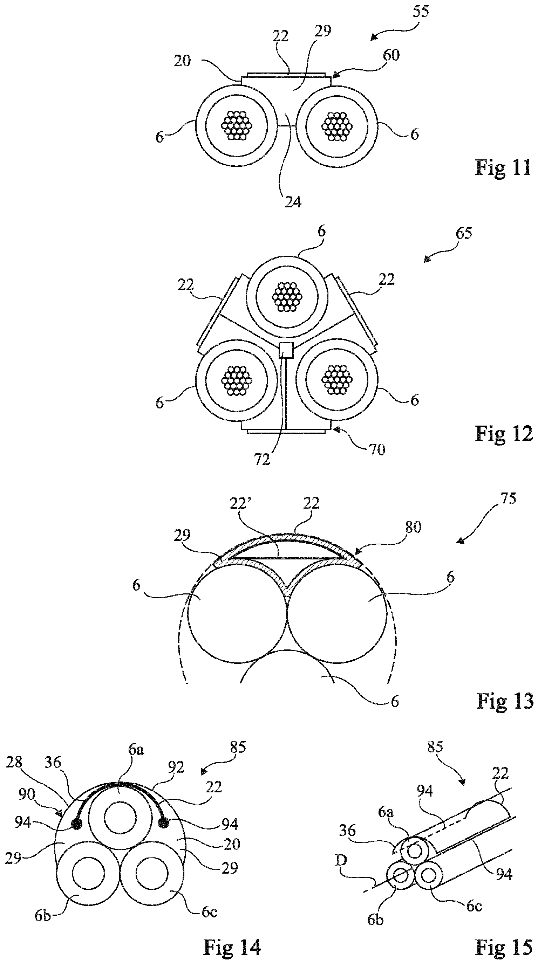

La figure 11 est une vue en coupe, partielle et schématique, d'un autre mode de réalisation d'un câble électrique multi-coeurs 55 comprenant un dispositif de détection à distance 60.

Dans le présent mode de réalisation, le câble 55 comprend une paire de conducteurs électriques 6. Le dispositif 60 de détection comprend l'ensemble des éléments du dispositif 10 représenté sur les figures 1 à 3 à la différence que le dispositif 60 ne comprend qu'une seule étiquettes RFID 22 et que le support 20 ne comprend qu'une seule branche 24 interposée entre les conducteurs 6, l'étiquette RFID 22 étant située sur la portion évasée 29 de la branche 24. A titre de variante, le support 20 peut comprendre deux branches 24 dans le prolongement l'une de l'autre et comprenant chacune une portion évasée 29 et le dispositif de détection 60 peut comprendre deux étiquettes RFID 22 fixées aux portions évasées 29.

Plusieurs dispositifs de détection 60 peuvent être répartis le long du câble électrique 54 sur une courte distance avec des orientations différentes afin d'assurer une détection d'au moins une étiquette RFID quelle que soit l'orientation du câble 55 par rapport au lecteur. A titre d'exemple, pour un câble 55 torsadé ayant un pas d'hélice de l'ordre de 1 m, l'écart entre dispositifs de détection 60 adjacents peut être d'environ 33 cm.

La figure 12 est une vue en coupe, partielle et schématique, d'un autre mode de réalisation d'un câble électrique multi-coeurs 65 comprenant trois conducteurs 6 et un dispositif de détection à distance 70.

Le dispositif 70 comprend l'ensemble des éléments du dispositif 10 représenté sur les figures 1 à 3 à la différence qu'il comprend un circuit électronique unique 72, par exemple une puce de circuit relié aux antennes des étiquettes RFID 22. Selon un mode de réalisation, le circuit électronique 72 est noyé dans le support 20.

Ceci permet de mutualiser certaines fonctions des étiquettes RFID 22 au sein du circuit électronique 72. A titre d'exemple, des moyens de mémorisation des étiquettes RFID 22 peuvent être mutualisés afin d'éviter des divergences des données stockées en mémoire d'un groupe d'étiquettes RFID 22, si une ou plusieurs étiquettes RFID 22 ne sont pas accessibles à la communication du fait d'une mauvaise orientation du câble 65.

La figure 13 est une vue en coupe, partielle et schématique, d'un autre mode de réalisation d'un câble électrique multi-coeurs 75 comprenant trois conducteurs 6 et un dispositif de détection à distance 80.

Le dispositif de détection à distance 80 comprend l'ensemble des éléments du dispositif de détection 60 représenté en figure 11 à la différence que le support 20 comprend seulement la portion évasée 29 s'étendant entre deux conducteurs 6 et ne comprend pas de branche interposée entre les deux conducteurs 6, les deux conducteurs 6 étant en contact l'un avec l'autre. Autrement dit, le support 20 comprend une portion évasée 29 présentant sur deux de ses faces une courbure complémentaire de la courbure d'un conducteur électrique 6. Ces deux faces courbes se rejoignent sans former de branche, de manière à autoriser un contact entre les deux conducteurs 6.

De préférence, le support 20 est en un matériau non conducteur électriquement. Comme illustré sur la figure 13, le support 20 comprend une portion évasée 29 occupant l'espace laissé libre entre un premier et un second conducteurs électriques 6 adjacents et le support 20 présente une face externe 28 courbe dont le rayon de courbure est sensiblement égal au rayon du cercle circonscrit à l'ensemble des conducteurs 6 et s'étend du premier conducteur électrique au second conducteur électrique.

Dans le présent mode de réalisation, l'étiquette RFID 22 est intégrée dans le support 20. L'étiquette RFID 22 est alors située sur le côté externe de la face externe 28 du support 20 dont le rayon de courbure est sensiblement égal au rayon du cercle circonscrit aux conducteurs électriques 6 dans le plan de section droite des conducteurs 6. La référence 22' illustre une autre position possible pour l'étiquette RFID. Il pourrait également être prévu que l'étiquette RFID soit disposée sur un côté interne de la face externe 28.

Dans le présent mode de réalisation, le support 20 peut s'étendre le long de la direction D du câble 75 et être intégré au câble 75 pendant la mise en torsade de celui-ci. Le support 20 peut avoir une forme de torsade avant son installation pour faciliter son assemblage. Le présent mode de réalisation peut aussi s'appliquer à des conducteurs 6 non torsadés et parallèles. Dans ce cas, il faut prévoir une gaine ou un film entourant le câble électrique 75 pour le maintien du support.

Selon un mode de réalisation, le câble électrique peut comprendre des premier, deuxième et troisième conducteurs isolés sensiblement de même diamètre, agencés en triangle, éventuellement au contact les uns des autres, et un quatrième conducteur électrique dont le diamètre est inférieur au diamètre des premier, deuxième et troisième conducteurs isolés et logés dans l'espace entre les premier et deuxième conducteurs isolés. Un dispositif de détection 80, tel que représenté en figure 13, peut alors être prévu dans l'espace entre les premier et troisième conducteurs isolés et/ou dans l'espace entre les deuxième et troisième conducteurs isolés.

Les figures 14 et 15 représentent un autre mode de réalisation d'un câble électrique multi-coeurs 85 comprenant un dispositif de détection à distance 90. Selon l'exemple de réalisation illustré, le câble 85 comprend trois conducteurs électriques 6.

Le dispositif de détection à distance 90 comprend l'ensemble des éléments du dispositif de détection 80 représenté en figure 13 à la différence que le support 20, représenté seulement en figure 14, comprend une première portion évasée 29 s'étendant entre les premier et deuxième conducteurs 6a, 6b et une deuxième portion évasée 29 s'étendant entre les deuxième et troisième conducteurs 6b, 6c. Selon cet exemple de réalisation, les première et deuxième portions évasées 29 sont reliées par une portion de liaison 92 qui recouvre le deuxième conducteur 6b. Dans le présent mode de réalisation, l'étiquette RFID 22, seule l'antenne 36 de l'étiquette RFID étant représentée en figure 15, est noyée dans le support 20 et l'antenne 36 s'étend depuis la première portion évasée 29 jusqu'à la deuxième portion évasée 29 en passant par la portion de liaison 92. A titre de variante, l'antenne RFID peut être fixée ou intégrée à l'une des faces externes 28 des portions évasées 29 en étant par exemple orientée vers l'extérieur du câble électrique multi-coeurs 85. De préférence, la portion de liaison 92 est la plus mince possible de manière à limiter l'encombrement du câble électrique multi-coeurs 85 tout en assurant la tenue mécanique du support 20. Dans le présent mode de réalisation, le support 20 ne comprend pas de branche interposée entre deux conducteurs 6, les conducteurs 6 étant en contact les uns avec les autres.

Dans le présent mode de réalisation, le support 20 peut s'étendre le long de la direction D du câble 85 et être intégré au câble 85 pendant la mise en torsade de celui-ci. Le support 20 peut avoir une forme de torsade avant son installation pour faciliter son assemblage.

De façon avantageuse, les brins 94 de l'antenne 36 RFID qui s'étendent selon la direction D sont éloignés des conducteurs 6. Ceci permet que le fonctionnement de l'étiquette RFID 22 soit moins perturbé par les conducteurs 6.

En outre, le fonctionnement de l'étiquette RFID 22 peut être moins sensible au positionnement de l'antenne 36. De plus, la portée du dispositif de détection à distance 90 peut être augmentée.

Dans les modes de réalisation décrits précédemment, l'antenne 36, peut, en vue de dessus, avoir une forme rectangulaire et comprendre des spires conductrices électriquement, chaque spire comprenant deux portions longitudinales, de préférence selon les grands côtés du rectangle, parallèles à l'axe D des conducteurs électriques et deux portions transversales, de préférence selon les petits côtés du rectangle. Les portions longitudinales des spires se répartissent selon deux faisceaux longitudinaux. De façon avantageuse, ces deux faisceaux longitudinaux ne sont pas tous deux à proximité d'un même conducteur électrique 6. En particulier, dans les modes de réalisation représentés sur les figures 1 à 3, 8 à 10, 11 et 13, ces deux faisceaux longitudinaux sont situés sur une même face du support 20, ou noyés dans le support à proximité d'une telle face, et sont situés au niveau de deux bords opposés de cette face, chacun des faisceaux étant proche d'un des deux conducteurs électriques encadrant cette face. En outre, dans le mode de réalisation représenté sur les figures 14 et 15, les deux faisceaux longitudinaux sont fixés à ou noyés dans deux portions évasées différentes du support.

Des modes de réalisation particuliers ont été décrits. Diverses variantes et modifications apparaîtront à l'homme de l'art. En particulier, bien que, dans les modes de réalisation décrits précédemment, le support 20 des dispositifs de détection s'étende de façon rectiligne selon l'axe D du câble, le support peut avoir une forme torsadée qui suit la forme des conducteurs 6 lorsque ceux-ci sont mis en torsade.

En outre, divers modes de réalisation avec diverses variantes ont été décrits ci-dessus. On note que divers éléments de ces divers modes de réalisation et variantes peuvent être combinés. A titre d'exemple, le dispositif de détection 50 représenté sur les figures 8 à 10 peut comprendre un seul circuit électronique relié à toutes les antennes RFID comme cela est décrit pour le dispositif de détection 70.

En outre, dans les modes de réalisation décrits précédemment, le dispositif de détection 10, 50, 60, 70 ou 80 s'étend seulement sur une partie de la longueur du câble électrique 5, 48, 55, 65 ou 75, plusieurs exemplaires du dispositif de détection pouvant être prévus le long du câble électrique. A titre de variante, pour chacun des modes de réalisation du câble électrique 5, 48, 55, 65 ou 75 décrits précédemment, le support 20 du dispositif de détection peut s'étendre sur plus de la majorité, notamment sur la totalité, de la longueur du câble électrique. Dans ce cas, des étiquettes RFID peuvent être disposées sur le même support le long du câble électrique. Dans le cas où les conducteurs du câble sont torsadés, le support 20 s'étendant sur plus de la majorité, notamment sur la totalité, de la longueur du câble électrique a également une forme torsadée qui assure une répartition sensiblement homogène angulairement des étiquettes RFID autour du câble électrique.

Plusieurs étiquettes RFID réparties selon la longueur du câble électrique peuvent être reliées à un même circuit électrique, de manière analogue à ce qui a été décrit précédemment en relation avec la figure 12.

**Revendications**

1. Dispositif de détection (10 ; 50 ; 60 ; 70 ; 80) comprenant :

   un support (20) destiné à être maintenu entre au moins deux conducteurs électriques (6) et comprenant une face (28), et
   au moins une antenne (36) d'échange de signaux radiofréquences liée mécaniquement audit support du côté de ladite face,
   **caractérisé en ce que**
   le support comprend pour chacun desdits au moins deux conducteurs, une portion évasée (29) dont une partie présente une forme complémentaire d'une partie du conducteur, la forme complémentaire présentant un rayon de courbure sensiblement égal au rayon du conducteur.

2. Dispositif selon la revendication 1, dans lequel le support (20) comprend au moins une branche (24) destinée à être interposée entre les deux conducteurs électriques (6).

3. Dispositif selon la revendication 1 ou 2, dans lequel l'antenne (36) est fixée à ladite face (28) ou est noyée dans le support (20) ou est imprimée sur le support (20).

4. Dispositif selon l'une quelconque des revendications 1 à 3, dans lequel le support (20) comprend au moins trois branches (24) destinées à être interposées entre au moins trois conducteurs électriques, au moins trois faces (28), et, pour chaque face, au moins une antenne (36) étant liée mécaniquement audit support du côté de ladite face.

5. Dispositif selon la revendication 4, dans lequel le support (20) comprend un corps central (26) duquel se projettent les branches (24).

6. Dispositif selon la revendication 4 ou 5, dans lequel chaque branche (24) comprend une portion évasée (29) destinée à s'étendre vers l'extérieur du câble (5) et délimitant l'une desdites faces (28).

7. Dispositif selon l'une quelconque des revendications 4 à 6, dans lequel chaque antenne (36) est destinée à être au moins en partie interposée entre le support (20) et l'un des conducteurs (6).

8. Dispositif selon l'une quelconque des revendications 4 à 7, comprenant un circuit électronique (72) connecté aux antennes (6).

9. Dispositif selon la revendication 8, dans lequel le circuit électronique (72) est noyé dans le support (20).

10. Dispositif selon l'une quelconque des revendications précédentes, dans lequel l'antenne (36) est contenue dans une surface qui a un rayon de courbure supérieur au rayon de chaque conducteur électrique (6).

11. Câble (5 ; 48 ; 55 ; 65 ; 75) comprenant au moins deux conducteurs électriques (6) et un dispositif de détection (10 ; 50 ; 60 ; 70 ; 80) selon l'une quelconque des revendications précédentes.

12. Câble selon la revendication 11, dans lequel l'antenne (36) comprend des spires conductrices électriquement, chaque spire comprenant deux portions longitudinales parallèles à l'axe des conducteurs électriques (6), lesdites deux portions longitudinales des spires se répartissant selon deux faisceaux, l'un des faisceaux longitudinaux étant plus proche de l'un desdits au moins deux conducteurs électriques et l'autre des faisceaux longitudinaux étant plus proche de l'autre desdits au moins deux conducteurs électriques.

13. Câble selon la revendication 11 ou 12, comprenant au moins des premier, deuxième et troisième conducteurs électriques (6) et dans lequel le support (20) comprend des première, deuxième et troisième branches (24), la première branche étant interposée entre les premier et deuxième conducteurs, la deuxième branche étant interposée entre les deuxième et troisième conducteurs et la troisième branche étant interposée entre les premier et troisième conducteurs.

14. Câble selon l'une quelconque des revendications 11 à 13, dans lequel la face (28) a un rayon de courbure égal à 10 % près au rayon du cercle circonscrit à l'ensemble des conducteurs électriques (6) composant le câble.

15. Câble selon l'une quelconque des revendications 11 à 14, dans lequel le support (20) comprend deux portions évasées (19) situées de part et d'autre de l'un desdits au moins deux conducteurs électriques (6) et une portion de liaison (92) reliant les deux portions évasées et recouvrant ledit conducteur électrique.

**Patentansprüche**

1. Detektionsvorrichtung (10; 50; 60; 70; 80), die Folgendes aufweist:

   einen Träger (20), der dazu bestimmt ist, zwischen mindestens zwei elektrischen Leitern (6) gehalten zu werden, und eine Fläche (28) aufweist, und
   mindestens eine Antenne (36) für den Austausch von Hochfrequenzsignalen, die mechanisch mit dem Träger auf der Seite der Fläche verbunden ist,
   **dadurch gekennzeichnet, dass**
   der Träger für jeden der mindestens zwei Leiter einen sich erweiternden Teil (29) aufweist, von dem ein Teil eine zu einem Teil des Leiters komplementäre Form aufweist, wobei die komplementäre Form einen Krümmungsradius hat, der im Wesentlichen gleich dem Radius des Leiters ist.

2. Vorrichtung nach Anspruch 1, wobei der Träger (20) mindestens einen Zweig (24) aufweist, der dazu bestimmt ist, zwischen den beiden elektrischen Leitern (6) aufgenommen zu werden.

3. Vorrichtung nach Anspruch 1 oder 2, wobei die Antenne (36) an der genannten Fläche (28) befestigt, in den Träger (20) eingelassen oder auf den Träger (20) aufgedruckt ist.

4. Vorrichtung nach einem der Ansprüche 1 bis 3, wobei der Träger (20) Folgendes aufweist, mindestens drei Zweige (24), die dazu bestimmt sind, zwischen mindestens drei elektrischen Leitern aufgenommen zu werden, mindestens drei Flächen (28) und für jede Fläche mindestens eine Antenne (36), die mechanisch mit dem Träger auf der Seite der Fläche verbunden ist.

5. Vorrichtung nach Anspruch 4, wobei der Träger (20) einen zentralen Körper (26) aufweist, von dem die Zweige (24) abstehen.

6. Vorrichtung nach Anspruch 4 oder 5, wobei jeder Zweig (24) einen sich erweiternden Teil (29) aufweist, der dazu bestimmt ist, sich zur Außenseite des Kabels (5) hin zu erstrecken und eine der genannten Flächen (28) zu begrenzen.

7. Vorrichtung nach einem der Ansprüche 4 bis 6, wobei jede Antenne (36) dazu bestimmt ist, zumindest teilweise zwischen dem Träger (20) und einem der Leiter (6) aufgenommen zu werden.

8. Vorrichtung nach einem der Ansprüche 4 bis 7, aufweisend eine elektronischen Schaltung (72), die mit den Antennen (6) verbunden ist.

9. Vorrichtung nach Anspruch 8, wobei die elektronische Schaltung (72) in den Träger (20) eingebettet ist.

10. Vorrichtung nach einem der vorhergehenden Ansprüche, wobei die Antenne (36) in einer Fläche mit einem Krümmungsradius enthalten ist, der größer als der Radius jedes elektrischen Leiters (6) ist.

11. Kabel (5; 48; 55; 65; 75) aufweisend mindestens zwei elektrische Leiter (6) und eine Detektionsvorrichtung (10; 50; 60; 70; 80) nach einem der vorhergehenden Ansprüche.

12. Kabel nach Anspruch 11, wobei die Antenne (36) elektrisch leitende Spulen aufweist, wobei jede Spule zwei parallel zur Achse der elektrischen Leiter (6) verlaufende Längsteile aufweist, wobei die beiden Längsteile der Spulen in zwei Bündeln verteilt sind, wobei eines der Längsbündel näher an einem der mindestens zwei elektrischen Leiter liegt und das andere der Längsbündel näher an dem anderen der mindestens zwei elektrischen Leiter liegt.

13. Kabel nach Anspruch 11 oder 12, aufweisend mindestens einen ersten, einen zweiten und einen dritten elektrischen Leiter (6), und wobei der Träger (20) einen ersten, einen zweiten und einen dritten Zweig (24) aufweist, wobei der erste Zweig zwischen dem ersten und dem zweiten Leiter angeordnet ist, der zweite Zweig zwischen dem zweiten und dem dritten Leiter angeordnet ist und der dritte Zweig zwischen dem ersten und dem dritten Leiter angeordnet ist.

14. Kabel nach einem der Ansprüche 11 bis 13, wobei die Fläche (28) einen Krümmungsradius aufweist, der innerhalb von 10 % des Radius des Kreises liegt, der von allen elektrischen Leitern (6), die das Kabel bilden, umschrieben wird.

15. Kabel nach einem der Ansprüche 11 bis 14, wobei der Träger (20) zwei sich erweiternde Teile (19) aufweist, die sich auf beiden Seiten eines der mindestens zwei elektrischen Leiter (6) befinden, sowie ein Verbindungsteil (92), das die beiden sich erweiternden Teile verbindet und den elektrischen Leiter überdeckt.

## Claims

1. A detection device (10; 50; 60; 70; 80) comprising:

   a support (20) intended to be held between at least two electrical conductors (6) and comprising a face (28), and at least one antenna (36) for exchanging radiofrequency signals mechanically connected to said support on the side of said face,
   **characterised in that**
   the support comprises, for each of the said at least two conductors, a flared part (29) a part of which has a shape complementary to a part of the conductor, the complementary shape having a radius of curvature substantially equal to the radius of the conductor.

2. The device according to claim 1, wherein the support (20) comprises at least one branch (24) intended to be interposed between the two electrical conductors (6).

3. The device according to claim 1 or 2, wherein the antenna (36) is fixed to the said face (28) or is embedded in the support (20) or is printed on the support (20).

4. The device according to any one of claims 1 to 3, wherein the support (20) comprises at least three branches (24) intended to be interposed between at least three electrical conductors, at least three faces (28), and, for each face, at least one antenna (36) being mechanically connected to said support on the side of said face.

5. The device according to claim 4, wherein the support (20) comprises a central body (26) from which protrude the legs (24) .

6. The device according to claim 4 or 5, wherein each branch (24) comprises a flared part (29) intended to extend towards the outside of the cable (5) and delimiting one of the said faces (28).

7. The device according to any one of claims 4 to 6, wherein each antenna (36) is intended to be at least partly interposed between the support (20) and one of the conductors (6) .

8. The device according to any one of claims 4 to 7, comprising an electronic circuit (72) connected to the antennae (6) .

9. The device according to claim 8, wherein the electronic circuit (72) is embedded in the support (20).

10. The device according to any one of the preceding claims, wherein the antenna (36) is included within a surface having a radius of curvature greater than the radius of each electrical conductor (6).

11. Cable (5; 48; 55; 65; 75) comprising at least two electrical conductors (6) and a detection device (10; 50; 60; 70; 80) according to any one of the preceding claims.

12. The cable according to claim 11, wherein the antenna (36) comprises electrically conductive coils, each coil comprising two longitudinal parts parallel to the axis of the electrical conductors (6), the said two longitudinal parts of the coils being distributed according to two bundles, one of the longitudinal bundles being closer to one of said at least two electrical conductors and the other of the longitudinal bundles being closer to the other of said at least two electrical conductors.

13. The cable according to claim 11 or 12, comprising at least first, second, and third electrical conductors (6), and wherein the support (20) comprises first, second, and third branches (24), the first branch being interposed between the first and second conductors, the second branch being interposed between the second and third conductors, and the third branch being interposed between the first and third conductors.

14. The cable according to any one of claims 11 to 13, wherein the face (28) has a radius of curvature equal to within 10 % of the radius of the circle circumscribed by all the electrical conductors (6) forming the cable.

15. The cable according to any one of claims 11 to 14, wherein the support (20) comprises two flared parts (19) located on either side of one of the said at least two electrical conductors (6) and a part of connexion (92) connecting the two flared parts and covering said electrical conductor.

Fig 1

Fig 2

Fig 3

**Fig 4**

**Fig 5**

Fig 6

Fig 7

Fig 8

Fig 9

Fig 10

Fig 11

Fig 12

Fig 13

Fig 14

Fig 15

**EP 3 631 480 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1754746
- WO 2008122401 A
- US 2010172618 A1
- US 2007120684 A1
- US 2009272794 A1
- DE 102004051594 A1
- US 9379442 B